# EUROPEAN PATENT APPLICATION

(11) **EP 4 671 788 A1**
(43) Date of publication of application: **31.12.2025**
(21) Application number: 24780259.8
(22) Date of filing: 26.03.2024
(51) Int. Cl.: G01R 31/385, H01M 10/42, H01M 10/48, H02J 7/00

(54) **CHARGE/DISCHARGE TEST SYSTEM**

(30) Priority: 30.03.2023 JP 2023054440
(71) Applicant: Tokyo Seimitsu Co., Ltd., Hachioji-shi, Tokyo 192-8515 (JP)
(72) Inventor: YOKOYAMA Sempei, Hachioji-city, Tokyo 1928515 (JP)
(74) Representative: Seemann & Partner Patentanwälte mbB
(86) International application number: PCT/JP2024/011859
(87) International publication number: WO 2024/204146

(57) **Abstract**

A charge/discharge test system includes: a test device 20-1 that performs a charge/discharge test on secondary batteries 15-1 to 15-n connected to the test device and acquires measurement data DT1 based on a first sampling interval f1, the measurement data being created from a signal indicating a battery state due to each of the test devices 20-1 to 20-m, the measurement data being to be analyzed to determine a battery characteristic; a large-capacity storage device 1 (100) that stores the measurement data; and an evaluation data output means that extracts the measurement data based on a second sampling interval f2 that is A times the first sampling interval, based on the stored measurement data, and outputs the extracted measurement data as evaluation data DT2, the A representing an integer of 2 or more. According to the charge/discharge test system, detailed data at the time of abnormality in a long-term test can be freely output, so that a detailed evaluation of current, voltage, temperature, or the like can be performed.

## Description

### Field

The present invention relates to a charge/discharge test system that performs a charge/discharge test on a rechargeable target, such as a secondary battery.

### Background

In recent years, based on a global trend toward tighter environmental regulations and reduced energy costs, there has been an increasing demand for electric vehicles. Electric vehicles (EVs) and fuel cell vehicles (FCVs) emit no carbon dioxide (CO₂) at all during traveling, and thus there has been a rapidly increasing demand for such vehicles due to the global "decarbonization" movement. Electric vehicles are vehicles that can travel only using the driving force of an electric motor, and electric vehicles (EVs) using secondary batteries and fuel cell vehicles (FCVs) using fuel cells have been known, in which the secondary batteries and the fuel cells each serve as a power supply source for a high output motor for traveling. There has been a largely expanding demand for such secondary batteries as key devices for supporting the electric vehicle (EV) technology, whereas there has been a growing demand for de-CO₂ and energy saving from row material mining to production and recycling as a total infrastructure for supporting electric vehicles or the like.

The same is true for facilities for testing after battery production, and there has been a demand for a further reduction in running costs and further energy saving for equipment itself in response to facility expansion. For reliability assurance, large-capacity secondary batteries for use in vehicle electrification, for example, are subjected to a long-term test, and then an evaluation test is performed to ascertain the characteristics thereof, using a vast amount of data obtained as a result.

For example, secondary batteries are used under severe conditions, such as frequent repetition of charging and discharging or sudden variations in load. Thus, at the time of production, a charge/discharge test device performs a charge test and a discharge test (referred to as a charge/discharge test), leading to strict management in quality.

Patent Literature 1 describes a low-rate measurement mode and a high-rate measurement mode because a charge/discharge test on a secondary battery is a long-duration test and is limited in transfer rate or in the frequency of acquisition, in which in the low-rate measurement mode, a measurement result from measurement of the characteristic of a secondary battery is subjected to transmission/reception with a charge/discharge test device through a LAN, and in the high-rate measurement mode, the measurement result is stored, in an analog signal manner, into a storage unit through a system bus inside a control device.

Patent Literature 2 states that, for assurance of an improvement in the rate of operation of facilities, a setting unit sets a charge/discharge pattern corresponding to a test charge/discharge object to be subjected to a charge/discharge test from among charge/discharge objects and then a power prediction pattern is generated based on the charge/discharge pattern.

### Citation List

### Patent Literature

Patent Literature 1: Japanese Patent Application Laid-Open No. 2016-121931
Patent Literature 2: Japanese Patent Application Laid-Open No. 2023-10581

### Summary

### Technical Problem

According to the above-described conventional technologies, output data due to a charge/discharge test system is stored into a HDD that is a storage device in a dedicated device control personal computer and then is used for data analysis/diagnosis. Typically, such data is acquired based on a predetermined time interval (sampling interval) and is recorded in order into the HDD.

In general, a battery evaluation test due to a charge/discharge test device often lasts over a long period, and a shortened sampling interval tends to cause a vast amount of acquired data. Thus, as disadvantages, the storage area of the HDD is cluttered and data analysis is made too complicated.

Thus, in some cases, the sampling interval is lengthened (made coarse) to a certain extent, such as approximately a few seconds to a few tens of seconds.

However, in a case where the sampling interval is coarse, any event caused between two sampling times (timings) is not recorded as a disadvantage. For example, even in a case where an important signal for evaluation of battery performance is generated between a point of sampling and another point of sampling, the signal is not recorded and thus is missed (since the time of generation is out of sampling timing).

In addition, even when the device stops due to a certain abnormality and an attempt is made to investigate the cause temporally retrospectively, any sign of the cause of the abnormality (specific event) is difficult to find if the sampling interval is coarse.

On the other hand, when the sampling interval is made fine (shortened), the amount of data is made vast as a disadvantage. An increase in the amount of data causes not only a cluttered storage area but also time-consuming data analysis (time-consuming extraction of a specific event) as disadvantages.

In general, a battery evaluation test is often performed on the same batteries or different batteries in parallel and simultaneously. In this case, as the amount of test data of one secondary battery increases, the amount of data being handled in the entire evaluation test increases significantly. A charge/discharge test on secondary batteries may be performed continuously for a few months, and thus, as disadvantages, it is complicated for a user to analyze a vast amount of data obtained from the test and it takes time to obtain an evaluation result.

For solution to the disadvantages in the above-described conventional technologies, an object of the present invention is to provide a charge/discharge test system that enables a long-term test, detailed data at the time of transition/abnormality to be output at any time after the test, and a detailed evaluation of a change in the behavior of a battery (e.g., current, voltage, or temperature) during the test.

### Solution to Problem

The present invention that achieves the above-described object is as follows.
[1] A charge/discharge test system comprising: a test device that performs a charge/discharge test on a secondary battery connected to the test device and acquires measurement data based on a first sampling interval, the measurement data indicating a battery state for characteristic analysis of the secondary battery; a large-capacity storage device that stores the measurement data; and an evaluation data output means that extracts the measurement data based on a second sampling interval that is A times the first sampling interval, based on the measurement data stored, and outputs the extracted measurement data as evaluation data, the A representing an integer of two or more.
[2] The charge/discharge test system according to [1], further comprising a control device that is connected to the test device through a controller and outputs, to the controller, an instruction for setting a charge/discharge pattern to the secondary battery, wherein the test device includes: an alternating-current power source; an alternating-current/direct-current converter; a plurality of charge/discharge devices bus-connected to the alternating-current/direct-current converter; and the controller that controls the charge/discharge devices to perform the charge/discharge test on the secondary battery, and the large-capacity storage device is connected to the test device.
[3] The charge/discharge test system according to [2], wherein the large-capacity storage device is connected to the test device through a network.
[4] The charge/discharge test system according to [2], wherein the large-capacity storage device is connected to the test device through the control device.
[5] The charge/discharge test system according to [1], wherein the evaluation data output means adjusts a value of the A, based on a request from a user or a previously determined condition.
[6] The charge/discharge test system according to [1], wherein from data for a predetermined period of time in the measurement data, based on a request from a user or a previously determined condition, the evaluation data output means re-extracts data based on a third sampling interval that is B times the first sampling interval and outputs the re-extracted data as second evaluation data, the B representing an integer that is not less than 1 and less than the A.
[7] The charge/discharge test system according to [6], further comprising a prediction unit that determines an abnormal characteristic pattern, based on comparison between the measurement data and a previously determined reference, and predicts or warningly issues a trend of abnormality.
[8] The charge/discharge test system according to [7], wherein the prediction unit includes a learned model having already performed machine learning with a training data set labeled based on an abnormality occurrence situation to a temporal transition in the measurement data, and predicts the trend of abnormality using the learned model, based on the measurement data acquired by the test device.

### Advantageous Effects of Invention

According to the present invention, provided can be a charge/discharge test system that enables a long-term test, detailed data at the time of transition/abnormality to be output at any time after the test, and a detailed evaluation of a change in the behavior of a battery (e.g., current, voltage, or temperature) during the test.

### Brief Description of Drawings

FIG. 1 is a block diagram illustrating main parts according to an embodiment of the present invention.
FIG. 2 is a block diagram illustrating a flow for outputting evaluation data according to the embodiment of the present invention.
FIG. 3 is an explanatory diagram illustrating the states of acquisition of evaluation data and measurement data based on mutually different sampling intervals.
FIG. 4 is an explanatory diagram illustrating the state of acquisition of measurement data according to the embodiment of the present invention.
FIG. 5 includes a graph of battery voltage and current as a function of time indicating exemplary measurement data and a graph of battery voltage and current as a function of time indicating exemplary evaluation data, according to the embodiment.
FIG. 6 is an explanatory diagram illustrating examples of acquisition of second evaluation data at the time of abnormality according to the embodiment.
FIG. 7 includes explanatory graphs for details of exemplary acquisition of second evaluation data at the time of abnormality according to the embodiment.
FIG. 8 is a graph of voltage as a function of time indicating examples of acquisition of measurement data according to the embodiment.
FIG. 9 is a block diagram illustrating main parts according to another embodiment of the present invention.

### Description of Embodiments

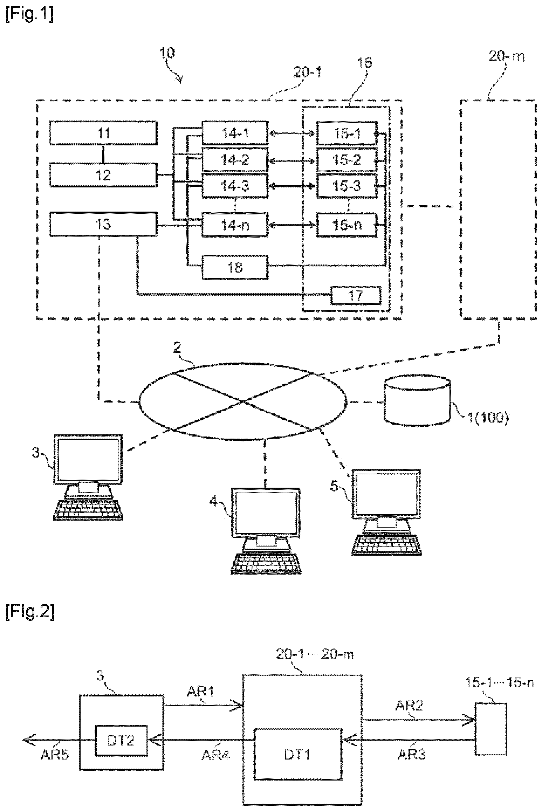

Embodiments of the present invention will be described in detail below with reference to the drawings. FIG. 1 is a block diagram illustrating main parts according to an embodiment of the present invention. A charge/discharge test system 10 performs a charge/discharge test on a plurality of secondary batteries 15-1, 15-2, 15-3, ..., and 15-n (n represents an integer) as charge/discharge test targets, in parallel.

The secondary batteries 15-1, 15-2, 15-3, ..., and 15-n are each, for example, a publicly known type of secondary battery, such as a lithium-ion battery, a nickel-metal hydride battery, or a solid-state battery, and each serve as a cell battery included in a high-voltage battery or the like for supplying power to, for example, a drive motor in an electric vehicle. For example, such cell batteries are stacked together to achieve a vehicular packed high-voltage battery (100 V or more, such as 200 to 400 V).

Test devices 20-1 to 20-m (m represents an integer) each include an alternating-current (AC) power source 11, an alternating-current/direct-current (AC/DC) converter 12, a controller 13, and a plurality of energy testing system (ET) devices (charge/discharge devices) 14-1, 14-2, 14-3, ..., and 14-n. The test devices 20-1 to 20-m are each connected to a network 2 through the corresponding controller 13. Note that the respective numbers represented by n and m may be identical to each other or different from each other.

A control device 3 is connected to the network 2 and inputs, for example, a test condition to each of the test devices 20-1 to 20-m. The AC/DC converter 12 is bus-connected to each of the ET devices 14-1, 14-2, 14-3, ..., and 14-n.

The controller 13 serves as a control device, such as a programmable logic controller (PLC), that controls the ET devices 14-1, 14-2, 14-3, ..., and 14-n, and includes a cache memory, based on a static RAM or SSD, that temporarily stores data and a network controller. The secondary batteries 15-1, 15-2, 15-3, ..., and 15-n are connected to the ET devices 14-1, 14-2, 14-3, ..., and 14-n, respectively.

Based on an input instruction from the control device 3, the controller 13 controls the AC/DC converter 12 and the ET devices 14-1, 14-2, 14-3, ..., and 14-n to perform a charge/discharge test on the secondary batteries 15-1, 15-2, 15-3, ..., and 15-n.

The control device 3 is, for example, a PC, a terminal different from any PC, a mobile terminal, or a tablet. The control device 3 is network-connected to the controller 13 and includes an operation unit including, for example, a keyboard and a mouse, and a display unit, such as a display.

The control device 3 outputs, to the controller, an instruction for setting respective charge/discharge patterns for the secondary batteries 15-1, 15-2, 15-3, ..., and 15-n to the ET devices 14-1, 14-2, 14-3, ..., and 14-n, from the operation unit. Thus, the controller 13 sets, to the ET devices 14-1, 14-2, 14-3, ..., and 14-n, the respective charge/discharge patterns for the secondary batteries 15-1, 15-2, 15-3, ..., and 15-n to be tested.

In the control device 3, the operation unit is used not only for an operation to individually set the respective charge/discharge patterns for the secondary batteries 15-1, 15-2, 15-3, ..., and 15-n but also for various types of operations to the test device 20-1, and the display unit is used to display various types of information. In addition, the control device 3 manages equipment information and configuration information on related services (e.g., IP address, port connection information, and line information) that exist on the network 2.

The secondary batteries 15-1, 15-2, 15-3, ..., and 15-n are installed in a thermostatic chamber 16 and are connected to the controller 13 through a temperature measurement unit 18 for temperature management. The thermostatic chamber 16 is temperature-controlled by the controller 13 through a thermostatic-chamber control unit 17. In accordance with the respective charge/discharge patterns for the secondary batteries 15-1, 15-2, 15-3, ..., and 15-n set by the controller 13, the ET devices 14-1, 14-2, 14-3, ..., and 14-n perform charging/discharging (or a charge/discharge test) on the secondary batteries 15-1, 15-2, 15-3, ..., and 15-n in the thermostatic chamber 16, respectively.

A NAS server 1 serves as a storage having a RAID function enabling files to be stored/shared through the network 2, and corresponds to a large-capacity storage device that has a specialized function for file management and is equipped with a large-capacity HDD or SSD having a capacity of a few terabytes or more.

In addition, preferably, the NAS server 1 has a function enabling management of backup and access privileges and functions as a virtual network or a remote desktop that allows remote access due to connection from a remote location to the network 2. Note that the control device 3 may have such functions.

Furthermore, the NAS server 1 may be a cloud storage that provides, as services, a computer resource and a service that allows files to be stored/shared on the Internet, due to communication with terminals 4 and 5 as client terminals through the network 2. In this case, upload/download of a file is performed through a web browser or an application.

In a case where a virtual network is constructed on the NAS server 1 or the control device 3, for example, already recorded information is databased due to operations, such as data insertion and searching, to a database management system in the virtual network, and then services are provided that allow browsing and modification of objects, such as HTML and images, through a Web browser on each of the terminals 4 and 5.

FIG. 2 is a block diagram illustrating a flow for outputting evaluation data. First, the control device 3 inputs a test condition (arrow AR1). The test condition may include, for example, the entire test time and a first sampling interval (cycle) for acquiring measurement data.

The first sampling interval is shorter than second and third sampling intervals described later and serves as a basic shortest sampling interval. The first sampling interval is not particularly limited and thus is simply required to be set as appropriate, depending on the hardware or software limitation of each part or the capacity of the large-capacity storage device. Note that the first sampling interval may be a fixed value determined in advance. In this case, the test condition may include no first sampling interval.

Next, the test devices 20-1 to 20-m each perform a charge/discharge test on the secondary batteries 15-1, 15-2, 15-3, ..., and 15-n, inside (arrow AR2).

Next, the test devices 20-1 to 20-m each obtain, based on the first sampling interval, a signal indicating a battery state, such as voltage or temperature, from each of the secondary batteries 15-1, 15-2, 15-3, ..., and 15-n to acquire measurement data DT1 (arrow AR3).

Next, based on the measurement data DT1 acquired based on the first sampling interval, the control device 3 extracts measurement data based on the second sampling interval to create evaluation data DT2 (arrow AR4).

Here, the second sampling interval is A times the first sampling interval (A represents an integer of 2 or more). For example, in a case where the first sampling interval is 100 milliseconds, the second sampling interval may be 1000 milliseconds, which is ten times the first sampling interval.

Due to the above-described processing, the number of data points included in the evaluation data DT2 is 1/A times that in the measurement data DT1, enabling a user to make an evaluation more easily. Then, the obtained evaluation data DT2 is output (arrow AR5).

Note that the second sampling interval may be set and stored in advance by the user or may be determined in advance.

Since the evaluation data DT2 has its sampling interval (cycle) set relatively long (coarse), the evaluation data DT2 is more suitable for overviewing a temporal change in measurement value. On the other hand, any event caused between a sampling timing and another sampling timing is not reflected. Thus, for example, if abnormality occurs and the test is terminated, for temporally retrospective investigation of any sign of the abnormality, evaluation with data based on a shorter sampling interval is suitable.

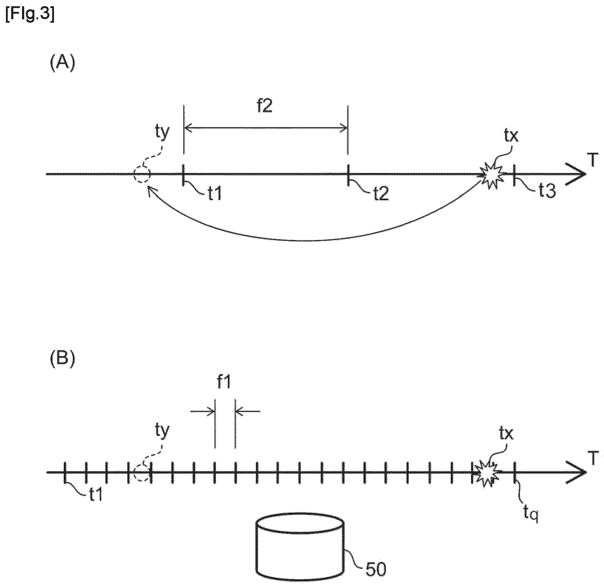

FIG. 3 is an explanatory diagram illustrating the states of acquisition of evaluation data and measurement data based on mutually different sampling intervals. FIG. 3(A) is an explanatory diagram of the evaluation data DT2 extracted based on a second sampling interval f2.

The horizontal axis represents time T, and data is extracted in the order of time t1, time t2, and time t3 based on the second sampling interval f2 for the evaluation data DT2.

In a case where the second sampling interval f2 is sufficiently large, the evaluation data DT2 facilitates understanding of a trend in overview data over the entire test time.

On the other hand, in a case where a certain abnormality occurs at a certain time tx, the evaluation data DT2 may include no measurement value at the time of occurrence of the abnormality. In a case where the charge/discharge test system stops due to the occurrence of abnormality (at time tx) after time t2, the data at time t3 is not included in the evaluation data DT2, and thus it can be understood that "the test is terminated due to the occurrence of a certain abnormality after time t2 but before time t3".

However, information as to when the abnormality occurred practically and what the time ty of occurrence of a sign of the abnormality is difficult to obtain from the evaluation data DT2.

That is, in a case where the test is terminated normally without any problem, it can be said that sufficient data is obtained for secondary-battery performance evaluation, provided that overviewing over the entire test time can be performed with the evaluation data DT2. On the other hand, in a case where abnormality occurs, the evaluation data DT2 alone may be insufficient for investigation of the cause of the abnormality.

FIG. 3(B) is an explanatory diagram of the measurement data DT1 measured based on a first sampling interval f1.

Similarly, the horizontal axis represents time T, and data is acquired from time t1 to time tq (q represents an integer) based on the first sampling interval f1.

According to the measurement data DT1, it is highly likely that the data at the time of occurrence of abnormality (at time tx) or the data immediately before or after the occurrence of abnormality has been acquired, and the time ty of occurrence of a sign of the abnormality can be ascertained due to temporally retrospective investigation.

On the other hand, all data is stored in a storage device 50, and thus the data capacity of a conventional charge/discharge test system (including a storage device inside) tends to be insufficient. In addition, because of acquisition of a large amount of data, in a case where data for entire overviewing is obtained, analysis tends to be complicated.

In addition, in a case where, for example, the user "wants to obtain the measurement data around time t3", which is the measurement data in a predetermined range, the measurement data around time t3 is required to be found from a vast amount of data, leading to a complicated operation.

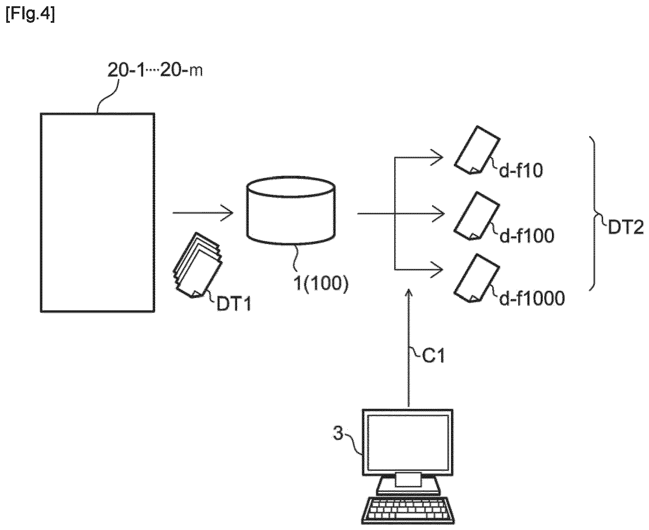

FIG. 4 is an explanatory diagram illustrating the state of acquisition of measurement data in an embodiment of the charge/discharge test system according to the present invention. The test devices 20-1 to 20-m each acquire the measurement data DT1, based on the first sampling interval, and store the measurement data DT1 into a large-capacity storage device 100. The large-capacity storage device 100 corresponds to the NAS server 1 in the example illustrated in FIG. 1.

The control device 3 including an evaluation data output means extracts data as the evaluation data DT2 from the measurement data DT1, based on the second sampling interval, in response to a request from the terminal 4 or 5 (arrow C1) based on the measurement data DT1 stored in the large-capacity storage device 100 or under a previously determined condition.

For example, the evaluation data DT2 is output as data d-f10 in a case where the second sampling interval is ten times the first sampling interval, as data d-f100 in a case where the second sampling interval is 100 times the first sampling interval, and as data d-f1000 in a case where the second sampling interval is 1000 times the first sampling interval.

Since the evaluation data DT2 is extracted from the already acquired measurement data DT1 as a configuration, the evaluation data DT2 may be output again from one measurement result as necessary. For example, in a case where, after relatively coarse evaluation data DT2 is initially output as the data d-f1000, it is determined that detailed evaluation data DT2 at the time of transition/abnormality is required, a finer (narrower) second sampling interval is simply required to be specified such that the evaluation data DT2 is output, for example, as the data d-f100 or the data d-f10.

That is, from one set of evaluation data, the entire characteristic and detailed evaluation data regarding battery abnormality/transient change can be obtained even after the test. The charge/discharge test lasts over a long period, and thus acquisition of various types of data due to a one-time test may be one of the important performance features.

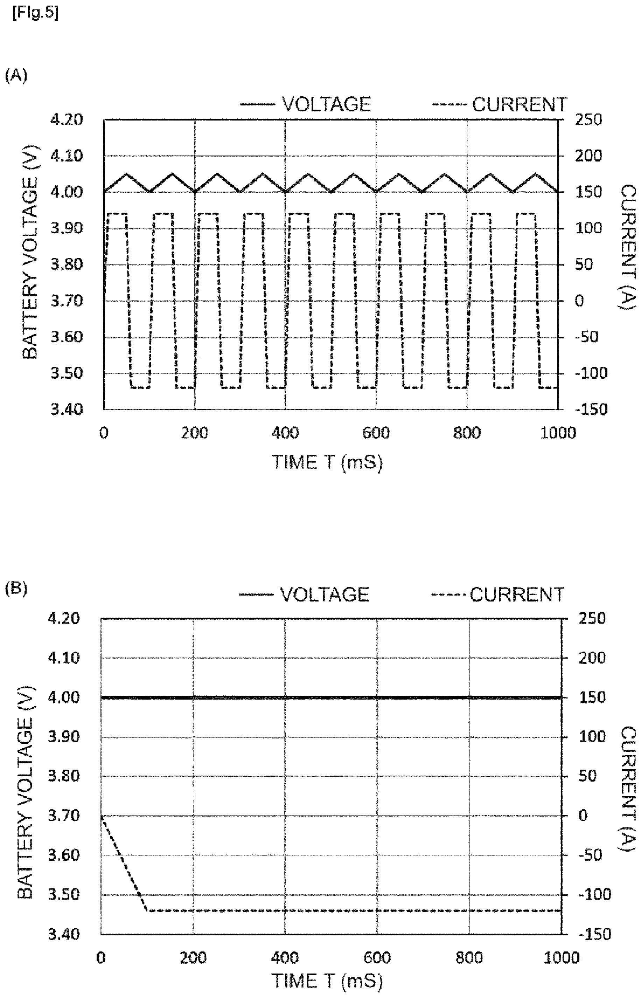

FIG. 5 includes a graph of battery voltage and current as a function of time indicating exemplary measurement data and a graph of battery voltage and current as a function of time indicating exemplary evaluation data. FIG. 5(A) is a graphical representation of the measurement data DT1 obtained based on the first sampling interval f1. From the result, detailed changes in the voltage and current of a secondary battery in an observation time (test time) ranging from 0 to 1000 ms can be understood.

On the other hand, FIG. 5(B) is a graphical representation of the evaluation data DT2 obtained based on the second sampling interval f2. From the result, as a whole, no large changes in the voltage and current of the secondary battery in the observation time (test time), which ranges from 0 to 1000 ms can be understood. If the evaluation data DT2 is acquired with no abnormality in the battery state of the secondary battery (in each piece of measurement data), the evaluation data DT2 may be sufficient for performance evaluation of the secondary battery.

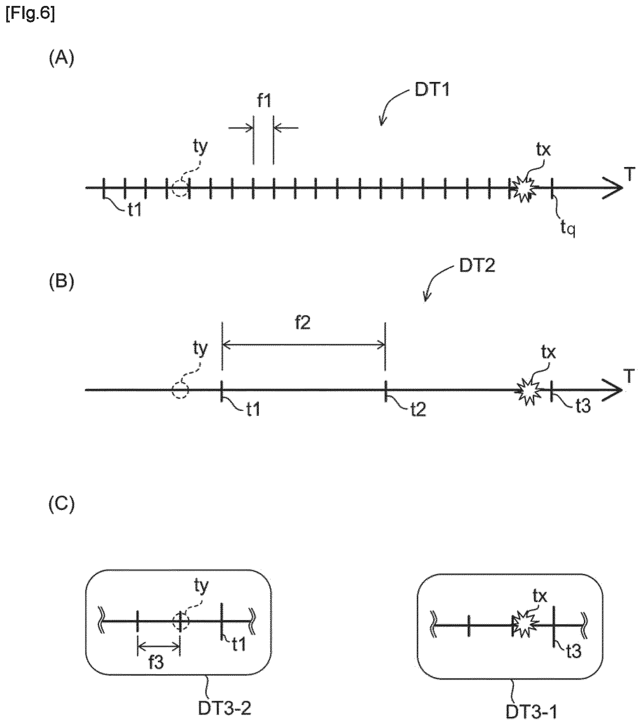

FIG. 6 is an explanatory diagram for exemplary outputs of second evaluation data. FIG. 6(A) is an explanatory diagram for the measurement data DT1 measured based on the first sampling interval f1, and FIG. 6(B) is an explanatory diagram for the evaluation data DT2 extracted from the measurement data DT1, based on the second sampling interval f2, which is A times the first sampling interval f1 (A is an integer of 2 or more).

The relationship between the measurement data DT1 and the evaluation data DT2 has already been described. The control device 3 (in which the evaluation data output means is implemented, for example, as application software) extracts data from the measurement data DT1, based on the second sampling interval f2, which is A times the first sampling interval f1, to obtain the evaluation data DT2 including the respective measurement values at time t1, time t2, and time t3.

FIG. 6(C) is an explanatory diagram for second evaluation data created due to re-extraction of data from the measurement data DT1 in the vicinity of the time tx of occurrence of abnormality and the time ty at which a signal as a sign of the abnormality can be obtained, based on a third sampling interval f3.

The above-described processing is performed by the control device 3 (in which the evaluation data output means is implemented, for example, as application software).

Second evaluation data DT3-1 corresponds to the data extracted from the measurement data DT1 for a certain period of time in the vicinity of the time tx of occurrence of the abnormality. The third sampling interval f3 is set not less than the first sampling interval f1 and shorter than the second sampling interval f2. Specifically, the third sampling interval f3 is adjusted to B times the first sampling interval f1. Here, B is an integer fulfilling the following expression: 1 ≤ B < A, and thus the third sampling interval f3 is shorter than the second sampling interval f2.

In addition, second evaluation data DT3-2 is extracted from the measurement data DT1 in the vicinity of the time ty of obtainment of a signal indicating a sign of the cause of the abnormality.

For the second evaluation data DT3-1 and the second evaluation data DT3-2, the range of re-extraction is limited to a predetermined period of time (range of interest), and thus a further reduction can be made in the number of data points for data to be evaluated even with the third sampling interval f3 made closer to the first sampling interval f1, leading to easier analysis.

The range of time of re-extraction may be specified by the user. In addition, the third sampling interval f3 may be determined based on a request from the user or may be determined in advance.

Even when the user notices abnormality while evaluating the characteristics of the secondary batteries 15-1, 15-2, 15-3, ..., and 15-n, based on the second sampling interval f2, the user can specify a predetermined time range to obtain detailed measurement data immediately before the abnormality, such as the second evaluation data DT3-1 or the second evaluation data DT3-2, from the large-capacity storage device 100.

According to the above-described configuration, the user can perform data analysis on the abnormal battery using one set of evaluation data. In addition, the user can obtain the measurement data a few cycles before the time of abnormality, as in FIG. 6(C). Then, using one set of evaluation data, the user can explore a trend in the measurement data before the abnormality and thus can obtain findings about prediction and warning.

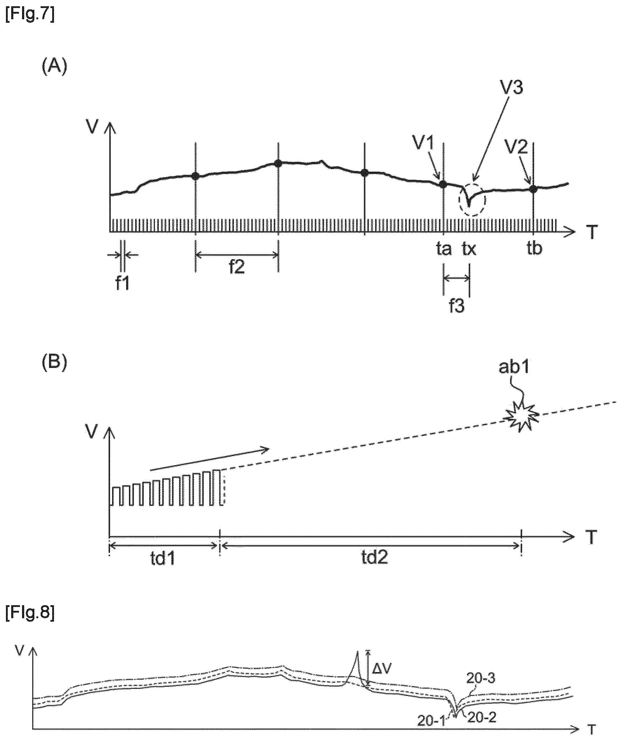

FIG. 7 includes explanatory graphs for details of exemplary acquisition of the second evaluation data at the time of abnormality. FIG. 7(A) is a graph indicating changes in the voltage of any of the secondary batteries 15-1, 15-2, 15-3, ..., and 15-n as a function of time. The first sampling interval f1 and the second sampling interval f2 are indicated on the X axis (time T).

Here, voltage V1 and voltage V2 correspond to data extracted based on the second sampling interval f2. That is, (ta, V1) and (tb, V2) are extracted as measurement values of (time T, voltage V) and then are involved into the evaluation data DT2.

An abnormal value generated at time tx (voltage V3) is not involved in the evaluation data DT2. In this case, the third sampling interval f3 is set at a proper value smaller than that of the second sampling interval f2 and is applied to the range of time ta to time tb, and then the second evaluation data is generated, so that the abnormal value can be detected. Specifically, the abnormal value can be detected, for example, as voltage change ΔV/Δt. Note that the voltage change ΔV/Δt may be monitored/stored by the control device 3 to display warning/caution during the test.

FIG. 7(B) illustrates the case of a gradually rising change in the voltage of a secondary battery as a function of time. The large-capacity storage device 100 stores the measurement data DT1 based on the first sampling interval f1. Thus, the control device 3 having a function of machine learning can predict, from the data in a measurement initial period td1, a transition in measurement value (trend of abnormality) in the following period td2 to generate a warning of abnormality occurrence ab1, using a learned model having already performed machine learning with a training data set labeled based on a trend of change in the measurement data DT1 (temporal transition in the measurement data DT1) and the presence or absence of occurrence of abnormality (occurrence situation).

Note that, in the above example, the abnormality occurrence ab1 is predicted from the data in the measurement initial period td1, but according to the above-described learned model, a warning of abnormality can be predicted and the warning can be generated from the data in any period.

Since the control device 3 manages the test devices 20-1 to 20-m, which are multiple channels, the control device 3 can statistically compare and analyze abnormal characteristic patterns from the same test cycle to predict and warningly issue a prospective characteristic and a trend of abnormality. In addition, the control device 3 can output diagnosis basis/quantitative data after the test is terminated, because of its function of machine learning.

Measurement items based on the evaluation data as the battery state of each of the secondary batteries 15-1, 15-2, 15-3, ..., and 15-n include voltage (V), current (A), power (W), the amount of charge current (Ah), the amount of discharge current (Ah), the amount of net current (Ah), the amount of charge power (Wh), the amount of discharge power (Wh), the amount of net power (Wh), and temperature (°C).

In addition, in each of the secondary batteries 15-1, 15-2, 15-3, ..., and 15-n, for example, a case where the voltage (V) is out of the range between the upper and lower limits, a case where the current (A) exceeds the upper limit, a case where the power (W) exceeds the upper limit, a case where the amount of charge current (Ah), the amount of discharge current (Ah), or the amount of net current (Ah) reaches the upper limit, a case where the amount of charge power (Wh), the amount of discharge power (Wh), or the amount of net power (Wh) reaches the upper limit, or a case where the temperature (°C) is out of the range between the upper and lower limits is detected as abnormality during the test or after the test.

FIG. 8 is a graph indicating voltage as a function of time with examples of acquisition of measurement data. Each piece of measurement data of FIG. 8 corresponds to any one of the secondary batteries 15-1, 15-2, 15-3, ..., and 15-n that the test device 20-1, 20-2, 20-3, ..., or 20-m is testing, and the pieces of measurement data are compared in voltage. This comparison function compares pieces of measurement data due to the test devices 20-1, 20-2, 20-3, ..., and 20-m, which are different channels during testing, and issues abnormality/warning notification in a case where difference ΔV is present. The basis for the determination of abnormality/warning can be clearly indicated together with such notification, and thus can be output as detailed evaluation data or the second evaluation data.

Note that the data comparison between the secondary batteries 15-1, 15-2, 15-3, ..., and 15-n can be also performed between the different test devices 20-1, 20-2, 20-3, ..., and 20-m or can be also performed between the secondary batteries 15-1, 15-2, 15-3, ..., and 15-n in each of the test devices 20-1, 20-2, 20-3, ..., and 20-m. Due to comparison of a large number of secondary batteries 15-1, 15-2, 15-3, ..., and 15-n (in the same test device or between different test devices), more accurate determination may be performed.

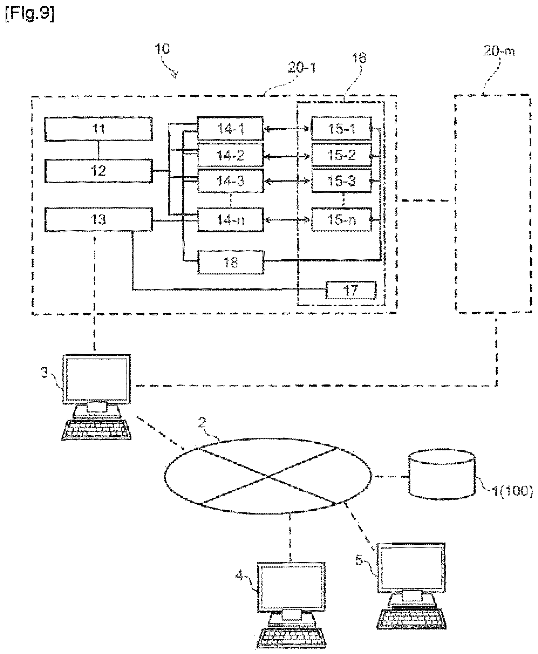

FIG. 9 is a block diagram illustrating main parts according to another embodiment. Referring to FIG. 1, the control device 3 is connected the respective controllers 13 provided to the test devices 20-1 to 20-m through the network 2. Referring to FIG. 9, a control device 3 is bus-connected to respective controllers 13 provided to test devices 20-1 to 20-m and is also connected to a network 2. Except the difference, the configuration in FIG. 9 is similar to that in FIG. 1. For example, a network controller is provided to the control device 3 to manage service configuration information (e.g., IP address, port connection information, and line information).

A charge/discharge test system corresponds to a computer system and has:
(1) a function of outputting the evaluation data DT2 as described with FIG. 2;
(2) a function of extracting data from the measurement data DT1 stored in the large-capacity storage device 100 based on the second sampling interval f2, which corresponds to a request from the user or is specified in advance, and outputting the data as the evaluation data DT2 as described with FIG. 4, and a function of displaying the measurement data DT1 and the evaluation data DT2 in a predetermined time range, separately, as in FIG. 5;
(3) a function of outputting the second evaluation data DT3-1 and the second evaluation data DT3-2 to acquire detailed data at the time of abnormality as described with FIG. 6;
(4) a function of determining an abnormal characteristic pattern based on the amount of variation in the measurement data of each of the secondary batteries 15-1, 15-2, 15-3, ..., and 15-n and predicting and warningly issuing a prospective characteristic and a trend of abnormality as described with FIG. 7; and
(5) a function of comparing, in voltage, pieces of measurement data each corresponding to any one of the secondary batteries 15-1, 15-2, 15-3, ..., and 15-n that the test device 20-1, 20-2, 20-3, ..., or 20-m is testing and clearly indicating the basis for the determination of abnormality/warning as described with FIG. 8.

The hardware configuration to achieve each of the above-described functions can be flexibly changed. In addition, according to the present invention, a computer program in which the functions described in the above embodiment are implemented is supplied to a computer, and at least one processor in the computer reads and executes the program to achieve the functions.

For example, in the description with FIG. 1, the large-capacity storage device 100 in FIG. 4 corresponds to the NAS server 1 connected to the test devices 20-1, 20-2, 20-3, ..., and 20-m through the network 2, but the large-capacity storage device 100 may be provided to each controller 13 or the control device 3. In addition, the large-capacity storage device 100 is not limited to a storage having a RAID function and thus may be an NVMe-connection M.2 SSD or a cloud storage available on the Internet.

Preferably, application software as a computer program or a library for achieving, for example, the above-described functions (1) to (5) is implemented in the control device 3 so as to be available to the terminals 4 and 5, but each controller 13 or the NAS server 1 may provide part thereof or the entirety thereof. In this case, the NAS server 1 may serve as a cloud storage to provide each function as a cloud service.

Furthermore, the function of machine learning described with FIG. 7 may be configured as a cloud service such that the control device 3 transmits measurement data to a server computer enabling high-speed processing through the network 2 and receives a result from statistical comparison and analysis of abnormal characteristic patterns.

### Reference Signs List

- 1: NAS SERVER
- 2: NETWORK
- 3: CONTROL DEVICE
- 4: TERMINAL
- 5: TERMINAL
- 10: CHARGE/DISCHARGE TEST SYSTEM
- 11: (ALTERNATING-CURRENT) POWER SOURCE
- 12: AC/DC CONVERTER
- 12: (ALTERNATING-CURRENT/DIRECT-CURRENT) CONVERTER
- 13: CONTROLLER
- 14-1 to 14-n: ET DEVICE
- 15-1 to 15-n: SECONDARY BATTERY
- 16: THERMOSTATIC CHAMBER
- 17: THERMOSTATIC-CHAMBER CONTROL UNIT
- 18: TEMPERATURE MEASUREMENT UNIT
- 20-1 to 20-m: TEST DEVICE
- 50: STORAGE DEVICE
- 100: LARGE-CAPACITY STORAGE DEVICE

## Claims

1. A charge/discharge test system comprising:
a test device that performs a charge/discharge test on a secondary battery connected to the test device and acquires measurement data based on a first sampling interval, the measurement data indicating a battery state for characteristic analysis of the secondary battery;
a large-capacity storage device that stores the measurement data; and
an evaluation data output means that extracts the measurement data based on a second sampling interval that is A times the first sampling interval, based on the measurement data stored, and outputs the extracted measurement data as evaluation data, the A representing an integer of two or more.

2. The charge/discharge test system according to claim 1, further comprising a control device that is connected to the test device through a controller and outputs, to the controller, an instruction for setting a charge/discharge pattern to the secondary battery, wherein
the test device includes: an alternating-current power source; an alternating-current/direct-current converter; a plurality of charge/discharge devices bus-connected to the alternating-current/direct-current converter; and the controller that controls the charge/discharge devices to perform the charge/discharge test on the secondary battery, and
the large-capacity storage device is connected to the test device.

3. The charge/discharge test system according to claim 2, wherein the large-capacity storage device is connected to the test device through a network.

4. The charge/discharge test system according to claim 2, wherein the large-capacity storage device is connected to the test device through the control device.

5. The charge/discharge test system according to claim 1, wherein the evaluation data output means adjusts a value of the A, based on a request from a user or a previously determined condition.

6. The charge/discharge test system according to claim 1, wherein from data for a predetermined period of time in the measurement data, based on a request from a user or a previously determined condition,
the evaluation data output means re-extracts data based on a third sampling interval that is B times the first sampling interval and outputs the re-extracted data as second evaluation data, the B representing an integer that is not less than 1 and less than the A.

7. The charge/discharge test system according to claim 6, further comprising a prediction unit that determines an abnormal characteristic pattern, based on comparison between the measurement data and a previously determined reference, and predicts or warningly issues a trend of abnormality.

8. The charge/discharge test system according to claim 7, wherein
the prediction unit includes a learned model having already performed machine learning with a training data set labeled based on an abnormality occurrence situation to a temporal transition in the measurement data, and
predicts the trend of abnormality using the learned model, based on the measurement data acquired by the test device.
